# EUROPEAN PATENT SPECIFICATION

(11) **EP 3 373 717 B1**
(45) Date of publication and mention of the grant of the patent: **15.12.2021**
(21) Application number: 15907774.2
(22) Date of filing: 04.11.2015
(51) Int. Cl.: H05K 13/04, H05K 13/08, G05B 19/418

(54) **COMPONENT MOUNTING SYSTEM AND COMPONENT MOUNTING DEVICE**
SYSTEM ZUR MONTAGE VON KOMPONENTEN UND VORRICHTUNG ZUR MONTAGE VON KOMPONENTEN
SYSTÈME DE MONTAGE DE COMPOSANTS ET PROCÉDÉ DE MONTAGE DE COMPOSANTS

(43) Date of publication of application: 12.09.2018
(73) Proprietor: Fuji Corporation, Chiryu-shi, Aichi 472-8686 (JP)
(72) Inventor: IISAKA, Jun, Chiryu Aichi (JP); OYAMA, Shigeto, Chiryu Aichi (JP)
(74) Representative: Grünecker Patent- und Rechtsanwälte PartG mbB
(86) International application number: PCT/JP2015/081001
(87) International publication number: WO 2017/077588

(56) References cited:
- DE-A1-102012 221 259
- JP-A- S6 080 299
- JP-A- S6 080 299
- JP-A- S6 175 600
- JP-A- H11 177 281
- JP-A- 2006 190 913
- JP-A- 2007 103 734
- JP-A- 2007 103 734
- US-A1- 2006 111 222

## Description

### Technical Field

The present invention relates to a component-mounting system and a component-mounting apparatus.

### Background Art

Conventionally, there are component-mounting apparatuses in which multiple lanes (for example, two) capable of conveying multiple types of boards are arranged in parallel and that use a head to pick up and hold supplied components and mount them onto boards conveyed in each lane (for example, refer to patent literature 1). The component-mounting apparatus described in PTL 1 checks, for each of the multiple types of boards, in which of the lanes a mounting operation can be performed and then determines the order in which the boards are to be supplied.

### Citation List

### Patent Literature

PTL 1: Japanese Unexamined Patent Application Publication No. 2013-84645 Further examples of component-mounting apparatuses are disclosed in DE 10 2012 221259 A1 and US 2006/111222 A1.

### Summary of Invention

### Technical Problem

In such a component-mounting apparatus having multiple lanes, if different types of boards are simultaneously conveyed in the lanes, the component-mounting apparatus may not be able to perform mounting operations with the same apparatus configuration due to the difference in the type of components to be mounted. For example, the type of head to be used may differ, or some components may not be loaded. Therefore, in a case where the types of boards conveyed in the lanes differ, it is necessary to check whether the apparatus configuration that is needed to perform the mounting operations is common to the different types of boards. However, if the configuration that is needed to perform the mounting operations on a board is checked every time boards are loaded, the checking process may take time and the production efficiency may decrease.

The main object of the present invention is to increase the board production efficiency of a system and an apparatus in which multiple lanes capable of conveying multiple types of boards are arranged in parallel.

### Solution to Problem

In order to achieve the main object, the present invention provides a component-mounting system according to independent claim 1. Preferred embodiments are laid down in the dependent claims.

In the first component-mounting system of the present invention, the multiple component-mounting apparatuses are configured to allow types of at least one of a production member to be exchanged in accordance with the type of the board, the production member including multiple types of component supply members for supplying different types of the components and multiple types of component holding members for holding different types of the components. The component-mounting system includes a storage section configured to store group information in which the multiple types of boards are divided into groups, each of which allows the mounting operation to be performed without requiring an operator to perform an exchange operation of exchanging the production members. By storing the group information, it is possible to reduce the processing time for checking whether the combination of boards to be processed in the lanes is a combination that does not require the exchange operation of exchanging the production members. Accordingly, it is possible to increase the board production efficiency of a system in which multiple lanes are arranged in parallel.

The first component-mounting system according to the present invention includes: an acquisition section configured to acquire the types of the boards on which the mounting operation is to be performed; and a combination-determining section configured to determine whether a combination of the types of the boards on which the mounting operation is to be performed in the multiple lanes is a combination that does not require the exchange operation of exchanging the production members based on the types of the boards acquired by the acquisition section and the group information stored in the storage section. In this case, it is possible to easily check whether the combination of boards to be processed in the multiple lanes requires the exchange operation of exchanging the production members by an operator by using the group information and to reduce the time required for the checking operation.

The first component-mounting system according to this aspect of the present invention includes a loading controller configured to, when it is possible to convey the board in a first lane from one of the component-mounting apparatuses on an upstream side in the board conveyance direction to another of the component-mounting apparatuses on a downstream side and if the combination-determining unit has determined that a combination of the board that is possible to convey in the first lane and a board loaded into the component-mounting apparatus on the downstream side in a second lane is a combination that does not require the exchange operation of exchanging the production members, perform control so as to load the board that is possible to convey in the first lane into the component-mounting apparatus on the downstream side. In this case, because a board in the first lane can be loaded while the component-mounting apparatus on the downstream side is performing a mounting operation on a board in the second lane, it is possible to immediately start a mounting operation on the next board.

In the first component-mounting system according this aspect of the present invention, the loading controller may be configured to perform control so as not to load the board that is possible to convey in the first lane into the component-mounting apparatus on the downstream side until the exchange operation of exchanging the production members is complete, if the combination-determining section has determined that the combination of the board that is possible to convey in the first lane and the board loaded into the component-mounting apparatus on the downstream side in the second lane is not a combination that does not require the exchange operation of exchanging the production members. If it is necessary to perform the exchange operation of exchanging the production members when switching between board types, depending on the arrangement of the production members to be exchanged or the like, the operability may decrease if a board is being conveyed in the lane. Therefore, by preventing a board in the first lane from being conveyed to the component-mounting apparatus on the downstream side, it is possible to prevent a decrease of the efficiency of the exchange operation of exchanging the production members.

In the first component-mounting system according to this aspect of the present invention, the combination-determining section in the component-mounting apparatus on the downstream side may be configured to determine whether the combination of the board that is possible to convey in the first lane and the board loaded into the component-mounting apparatus on the downstream side in the second lane is a combination that does not require the exchange operation of exchanging the production members.

The first component-mounting system according the present invention may comprise an indication section configured to indicate information that the operator needs to perform the exchange operation of exchanging the production members if the combination-determining section determines that the combination of the types of boards on which the mounting operation is to be performed in the multiple lanes is not a combination that does not require the exchange operation of exchanging the production members. In this case, the operator can prepare for the exchange operation by, for example, preparing production members to be exchanged, and therefore, it is possible to reduce the time required for the exchange operation of exchanging the production members.

A component-mounting apparatus according to the present invention is defined in independent claim 5.

The component-mounting apparatus according to the present invention is configured to allow types of at least one of a production member to be exchanged in accordance with the type of the board, the production member including multiple types of component supply members for supplying different types of the components and multiple types of component holding members for holding different types of the components. The component-mounting apparatus includes a storage section configured to store group information in which the multiple types of boards are divided into groups, each of which allows the mounting operation to be performed without requiring an operator to perform an exchange operation of exchanging the production members. By storing the group information, it is possible to reduce the processing time for checking whether the combination of boards to be processed in the lanes is a combination that does not require the exchange operation of exchanging the production members. Accordingly, it is possible to increase the board production efficiency of an apparatus in which multiple lanes are arranged in parallel.

### Brief Description of Drawings

[Fig. 1] Fig. 1 is a schematic view of component-mounting system 10.
[Fig. 2] Fig. 2 is a schematic view of component-mounting apparatus 12.
[Fig. 3] Fig. 3 is a block diagram illustrating elements related to control of component-mounting apparatus 12 .
[Fig. 4] Fig. 4 is a flowchart of an example of a group-specification-accepting process.
[Fig. 5] Fig. 5 illustrates production-member information stored on HDD 83 of management apparatus 80.
[Fig. 6] Fig. 6 illustrates grouped-board-type information stored on HDD 83 of management apparatus 80.
[Fig. 7] Fig. 7 is a flowchart of an example of a production-job-reception process.
[Fig. 8] Fig. 8 illustrates production-schedule information stored on HDD 73 of controller 70.
[Fig. 9] Fig. 9 is a flowchart of an example of a board-loading process.
[Fig. 10] Fig. 10 illustrates a state in which boards are being produced in a first lane and a second lane.
[Fig. 11] Fig. 11 illustrates a state in which boards are being produced in the first lane and the second lane.

### Description of Embodiments

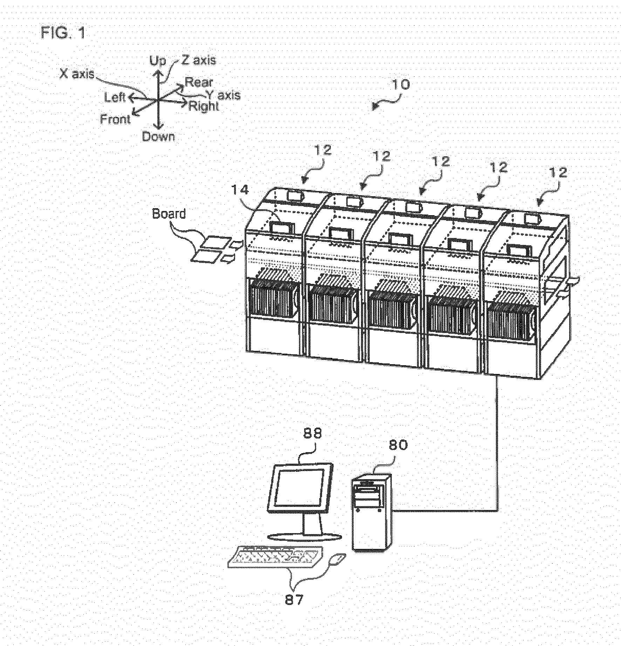

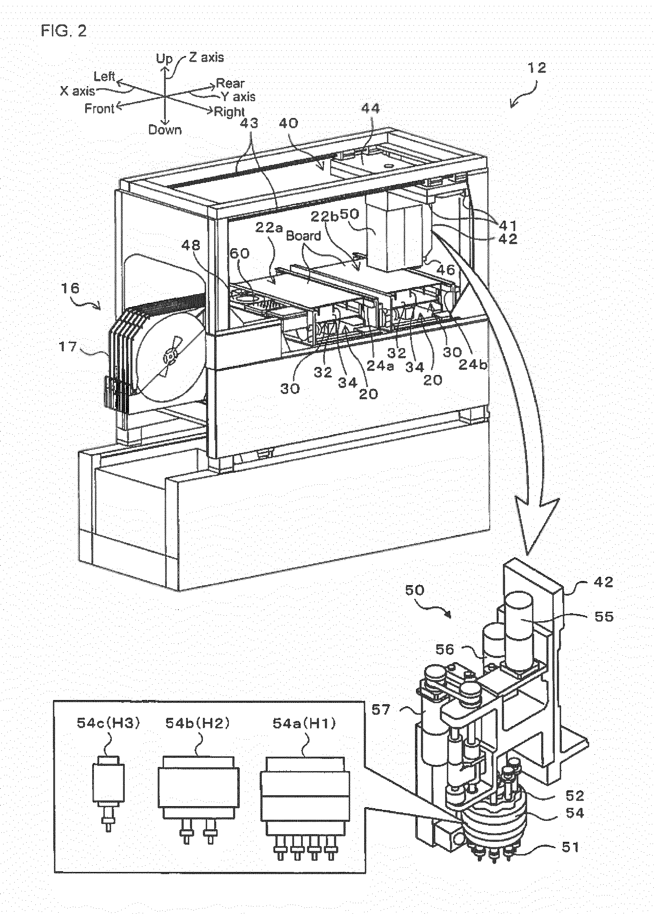

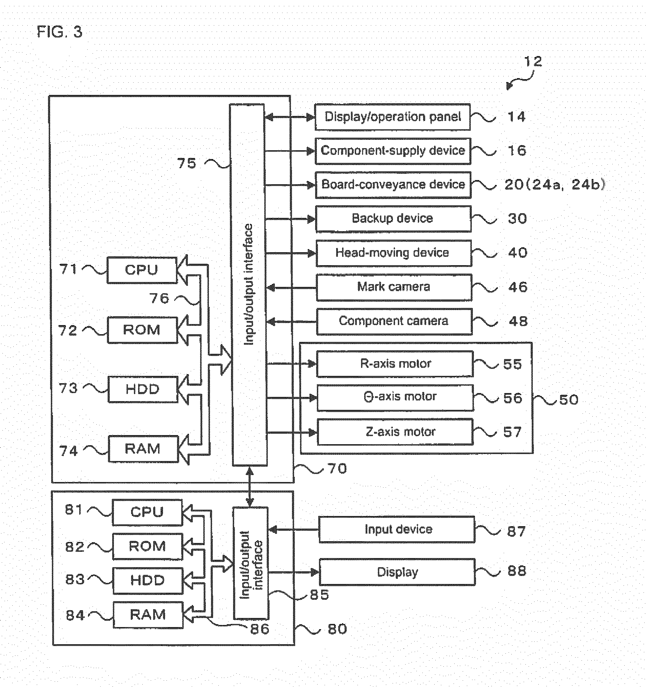

Hereinafter, embodiments of the present invention will be described. Fig. 1 is a schematic view of component-mounting system 10, Fig. 2 is a schematic view of component-mounting apparatus 12, and Fig. 3 is a block diagram illustrating elements related to control of component-mounting apparatus 12. The left-right direction in Figs. 1 and 2 is the X-axis direction, the front-back direction is the Y-axis direction, and the up-down direction is the Z-axis direction.

Component-mounting system 10 is a system that performs a mounting operation of mounting various types of components on a flat board (also referred to as "production"), and as illustrated in Fig. 1, component-mounting system 10 includes multiple component-mounting apparatuses 12, which are arranged in the board conveyance direction, and management apparatus 80, which manages the entirety of the system. Although not illustrated, component-mounting system 10 includes, in addition to component-mounting apparatuses 12, a printing apparatus that prints solder on a board, a reflow apparatus that performs a reflow operation on a board on which components are mounted, and the like. In the present embodiment, component-mounting system 10 is capable of performing the mounting operation of mounting components on multiple types of boards. Examples of multiple types of boards include boards having different sizes and boards on which different types of components are to be mounted.

As illustrated in Fig. 2, component-mounting apparatus 12 includes component-supply device 16 that supplies components; board-conveyance device 20 that conveys boards; and backup device 30 that supports the board, which is conveyed by the board-conveyance device 20, from below. Component-mounting apparatus 12 further includes head unit 50 to which head 54, having nozzle 51 for holding a component by suction, is attached; head-moving device 40 that moves head unit 50 (head 54) in the XY directions; and controller 70 that controls the entirety of component-mounting apparatus 12 (see Fig. 3).

In component-supply device 16, multiple tape feeders 17 are arranged in the left-right direction (X-axis direction). Each of the tape feeders 17 supplies components by drawing tape, in which the components are housed, from a reel. A predetermined upper-limit number of tape feeders 17 can be removably loaded in component-mounting apparatus 12. Therefore, an operator can remove a tape feeder 17 that contains a type of components not necessary for a type of board on which a mounting operation is to be performed, and the operator can attach a tape feeder 17 that contains a type of components necessary for the type of board on which the mounting operation is to be performed. That is, the operator exchanges the types of tape feeders 17 in accordance with the board type.

Board-conveyance device 20 is a dual-lane conveyance device in which two board-conveyance paths, first lane 22a and second lane 22b, are arranged side by side in the left-right direction (X direction). Belt conveyer devices 24a (first conveyance device) and 24b (second conveyance device) are each disposed in a corresponding lane. Board-conveyance device 20 conveys boards in first and second lanes 22a and 22b from left to right in the X direction (conveyance direction) by driving belt conveyer devices 24a and 24b.

Backup device 30 is disposed in each of first lane 22a and second lane 22b. Backup device 30 includes backup plate 32 that can be lifted or lowered by a lifting/lowering device (not shown), and multiple backup pins 34 that stand on backup plate 32. When a board is conveyed to a position above the backup plate 32 by board-conveyance device 20, backup device 30 supports the board from below by lifting backup plate 32.

Head-moving device 40 includes X-axis guide rails 41, X-axis slider 42, Y-axis guide rails 43, and Y-axis slider 44. Y-axis slider 44 is slidably attached to the pair of left and right Y-axis guide rails 43, which are fixed to component-mounting apparatus 12 and which extend in the front-back direction. The pair of front and back X-axis guide rails 41, which extend in the left-right direction, are disposed on a lower surface of Y-axis slider 44. X-axis slider 42 is attached to X-axis guide rails 41 so as to be slidable in the left-right direction. Head unit 50 moves in the left-right direction due to movement of X-axis slider 42 in the left-right direction and moves in the front-back direction due to movement of Y-axis slider 44 in the front-back direction. Sliders 42 and 44 are each driven by a motor (not shown).

Multiple types of heads 54, for example, three types of heads 54 including first to third heads 54a to 54c can be attached to and removed from head unit 50. In the present embodiment, while component-mounting apparatus 12 is not operating, an operator exchanges a head 54 attached to head unit 50 with a head 54 of a type that is necessary for a mounting operation. First head 54a (head type H1) includes twelve nozzle holders 52 arranged in a circumferential direction, and twelve nozzles 51 can be attached to first head 54a. Second head 54b (head type H2) includes four nozzle holders 52 arranged in a circumferential direction, and four nozzles 51 can be attached to a second head 54b. Third head 54c (head type H3) includes one nozzle holder 52 on an axial line, and one nozzle 51 can be attached to third head 54c. Nozzles 51, which are attached to heads 54 (first to third heads 54a to 54c), each pick up (hold) a component at an end thereof by suction using negative pressure, and release the picked up (held) component using positive pressure. Head unit 50 includes R-axis motor 55 that rotates nozzles 51 in the circumferential direction when first head 54a or second head 54b is attached, θ-axis motor 56 that rotates (revolves) each of the nozzle holders 52 around an axial line (θ-axis) thereof, Z-axis motor 57 that lowers the nozzle holder 52 (nozzle 51) at a predetermined position on the rotation path of nozzles 51, and a cylinder (not shown) that lifts or lowers a holder that holds head 54. When third head 54c is attached, head unit 50 causes R-axis motor 55 to operate as a θ-axis actuator and causes the cylinder to operate as a Z-axis actuator.

Component-mounting apparatus 12 further includes a display/operation panel 14 (see Figs. 1 and 3), which is a touchscreen panel, for displaying various types of information and accepting input from an operator. As illustrated in Fig. 2, component-mounting apparatus 12 includes mark camera 46 that captures an image of a mark on a board, component camera 48 that captures an image of a component held by nozzle 51, and nozzle rack 60 that stores multiple types of nozzles 51. Nozzle rack 60 can hold a predetermined upper-limit number of nozzles 51. A nozzle 51 held in nozzle rack 60 can be automatically exchanged with a nozzle 51 attached to a nozzle holder 52 of head unit 50. While component-mounting apparatus 12 is not operating, an operator can take out from nozzle rack 60 a type of nozzle 51 that is not necessary for a board type on which a mounting operation is to be performed, and the operator can set in nozzle rack 60 a type of nozzle 51 that is necessary for the board type on which a mounting operation is to be performed. That is, the operator exchanges the types of nozzles 51 in accordance with the board type.

As illustrated in Fig. 3, controller 70 includes CPU 71, ROM 72, HDD 73, RAM 74, input/output interface 75, and the like. These are electrically connected via bus 76. Controller 70 outputs a display signal to display/operation panel 14 and outputs drive signals to board-conveyance device 20, backup device 30, head-moving device 40, head unit 50, and the like. Controller 70 receives an operation signal from display/operation panel 14 and receives image signals from mark camera 46 and component camera 48. Controller 70 is communicatively connected to management apparatus 80 and exchanges data and control signals with management apparatus 80.

As illustrated in Fig. 3, management apparatus 80 includes CPU 81, ROM 82, HDD 83, RAM 84, input/output interface 85, and the like. These are electrically connected via a bus 86. Management apparatus 80 further includes input device 87 such as a mouse or a keyboard, display 88, and the like. As described above, component-mounting apparatus 12 according to the present embodiment can perform a mounting operation on multiple types of boards. Since different types of components are to be mounted on different types of boards, the type of tape feeder 17 to be used may differ, and the type or nozzle 51 and the type of head 54 to be used may differ. However, depending on the combination of board types, it may be possible to simultaneously load various types of tape feeders 17 to be used, it may not be necessary to exchange the heads 54 to be used, or it may be possible to simultaneously store in advance in nozzle rack 60 various types of nozzles 51 to be used. That is, depending on the combination of board types, when switching between board types, it may not be necessary for an operator to exchange tape feeders 17 (component-supply members) or to exchange nozzles 51 or heads 54 (component-holding members). Therefore, for such a combination of board types, after conveying the boards to the two lanes, component-mounting apparatus 12 can continuously perform mounting operations without an operator performing an exchange operation. Such a combination of board types will be referred to as "a combination that does not require an operation of exchanging production members" or "a combination that allows continuous operation (concurrent operation) to be performed". Management apparatus 80 and controller 70 of component-mounting apparatus 12 according to the present embodiment manage the board types that form a combination that allows continuous operations to be performed as the same "group" (production group). HDD 83 stores information about component-supply members and component-holding members necessary for each board type (production-member information, described below) and information about board types divided into groups (grouped-board-type information, described below). HDD 83 also stores, for example, information about the number of boards of each board type to be produced.

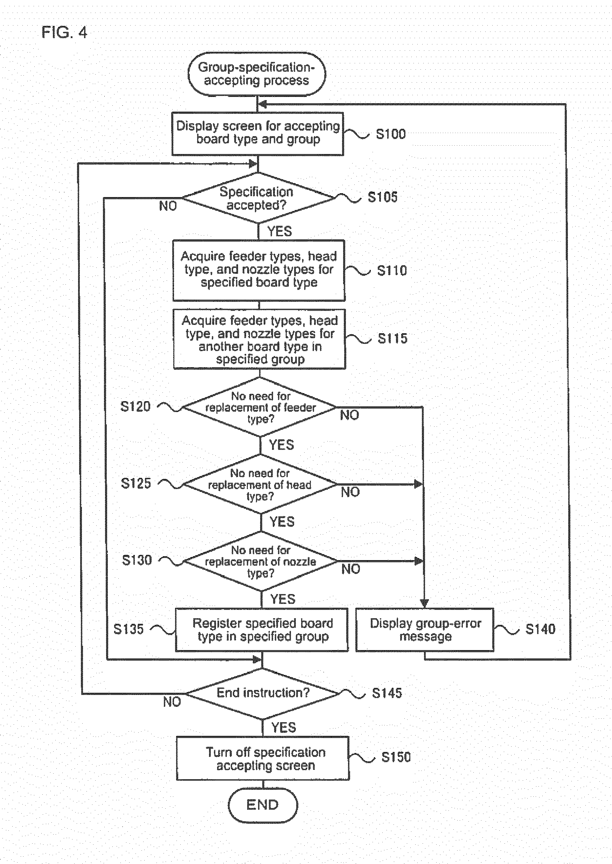

Hereinafter, component-mounting system 10 according to the present embodiment, which is configured as described above, will be described. Fig. 4 is a flowchart of an example of a group-specification-accepting process. A program for executing this routine is stored on HDD 83 of management apparatus 80. This routine is executed when manual specification of a group of board types is selected on a menu screen displayed on display 88.

In the group-specification-accepting process, first, CPU 81 of management apparatus 80 displays, on display 88, a specification-accepting screen for accepting specification of a board type and a group (S100), and waits until the specification is accepted following input by an operator using input device 87, such as a mouse or a keyboard (S105). Although not illustrated, the specification-accepting screen displays input boxes for inputting a board type and a group, a confirmation button for confirming the input contents, a finish button for finishing input, and the like. When an operator inputs specification contents to the input boxes for imputing a board type and a group and presses the confirmation button, CPU 81 determines that the specification has been accepted and acquires feeder types, a head type, and nozzle types used for performing mounting operations on the specified board type (S110).

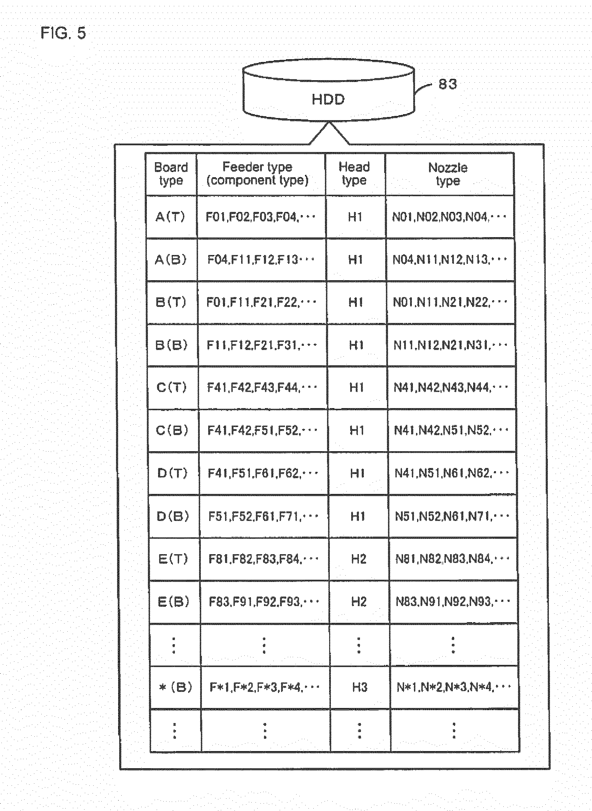

Fig. 5 illustrates production-member information stored on HDD 83 of management apparatus 80. As illustrated in the figure, the production-member information is information in which the board type is associated with feeder types (component types), which are the types of feeders 17 containing components that need to be mounted, the head type, which is the type of head 54 necessary for mounting the components, and the nozzle types, which are the types of nozzles 51 necessary for mounting the components. That is, the production-member information is information about the types of production members (feeder types, head type, and nozzle types) to be used for mounting operations performed on each board type. In the present embodiment, some boards may be processed as follows: the board is loaded into component-mounting apparatus 12 with the top surface facing upward; components are mounted on the top surface; a reflow operation is performed using a reflow apparatus; subsequently, the board is conveyed into the component-mounting apparatus 12 again with the bottom surface facing upward; components are mounted on the bottom surface; and then, a reflow process is performed again using the reflow apparatus. That is, components may be mounted on both surfaces of some boards. Therefore, the board types are named so that each board name (boards A, B, C, D, E, ...) and the top or bottom surface ([T] or [B]) are distinguishable. For example, board type A(T) represents the top surface of board A, and board type A(B) represents the bottom surface of board A. The input box of the specification-accepting screen for inputting the board type allows input of a board name and a top or bottom surface.

In step S110, CPU 81 acquires the feeder types, the head type, and the nozzle types corresponding to the board type by reading these types from the production-member information stored on HDD 83. Alternatively, an operator may input or may select, from a list or the like, the feeder types, the head type, and the nozzle types on the specification-accepting screen. In this case, in step S110, CPU 81 may acquire the feeder types, the head type, and the nozzle types that the operator has input or selected.

Next, CPU 81 acquires the feeder types, the head type, and the nozzle types for performing mounting operations on another board type in the specified group (S115). The other board type in the specified group is a board type registered in the group in a group-specification-accepting process that has been performed previously. CPU 81 determines whether an exchange operation by an operator is necessary for each of the combinations of the feeder types, the head types, and the nozzle types acquired in steps S110 and S115. That is, CPU 81 determines whether the feeder types in each combination do not require an exchange operation by an operator (S120), whether the head types in each combination do not require the operator to perform an exchange operation (S125), and whether the nozzle types in each combination do not require the operator to perform an exchange operation (S130). In step S120, CPU 81 determines whether the number of tape feeders 17 needed to perform a mounting operation on two board types is less than or equal to the predetermined upper-limit number of loadable tape feeders 17. In step S125, CPU 81 determines whether the heads 54 needed for production of the two board types are of the same type. In step S130, the CPU 81 determines whether the number of nozzles 51 needed for production of the two board types is less than or equal to the predetermined upper-limit number of holdable nozzles 51. That is, in steps S120 to S135, it is determined whether the combination of the board type specified in the current process and another board type in the specified group is a combination of board types that allows continuous operation to be performed.

In the example shown in Fig. 5, the head type is common to the combination of board types A(T) and A(B), and some of the feeder types and some of the nozzle types are also common to the combination of board types A(T) and A(B). It is assumed that the sum of the number of feeders 17 of feeder types (F01, F02, F03, F04, etc.) needed to perform mounting operations on board type A(T) and the number of feeders 17 of feeder types (F04, F11, F12, F13, etc.) needed to perform mounting operations on board type B(T) is less than or equal to the upper-limit number of loadable feeders 17 and that the feeders 17 can be set simultaneously. It is also assumed that the sum of the number of nozzles 51 of nozzle types (N01, N02, N03, N04, etc.) needed to perform mounting operations on board type A(T) and the number of nozzles 51 of nozzle types (N04, N11, N12, N13, etc.) needed to perform mounting operations on board type B(T) is less than or equal to the upper-limit number of holdable nozzles 51 and that the nozzles 51 can be set simultaneously. Therefore, when switching between board types A(T) and A(B), it is not necessary for an operator to exchange feeders 17, nozzles 51, or head 54. That is, the combination of board types A(T) and A(B) is a combination that allows continuous operation to be performed. Likewise, any combination of board types A(T), A(B), B(T), and B(B) is a combination that allows continuous operation to be performed, and therefore, board types A(T), A(B), B(T), and B(B) are managed as the same group. When such board types are to be processed, CPU 81 makes an affirmative determination in each of steps S120 to S130.

The head type for board type C(T) is the same as that for the board types A(T), A(B), B(T), and B(B). However, it is assumed that the sum of the number of feeders 17 of feeder types needed to perform mounting operations on the board type C(T) and the number of feeders 17 of feeder types needed to perform a mounting operation on the board types A(T), A(B), B(T), and B(B) exceeds the upper-limit number of loadable feeders 17 and that the feeders 17 cannot be set simultaneously. Moreover, it is assumed that the sum of the number of nozzles 51 of nozzle types needed to perform a mounting operation on the board type C(T) and the number of nozzles 51 of nozzle types needed to perform a mounting operation on the board types A(T), A(B), B(T), and B(B) exceeds the upper-limit number of holdable nozzles 51 and that the nozzles 51 cannot be set in the nozzle rack 60 simultaneously. Therefore, when switching between the board types C(T) and any of A(T), A(B), B(T), and B(B), it is necessary for an operator to exchange the feeders 17 and the nozzles 51. That is, the board type C(T) cannot be included in the same group as the board types A(T), A(B), B(T), and B(B). If a board type like the board type C(T) is specified as being in the group of the board types A(T), A(B), B(T), and B(B), the CPU 81 makes a negative determination in step S120 or S130.

If the CPU 81 makes affirmative determinations in all of steps S120 to S130 because exchange of the feeder type, the head type, and the nozzle type is not necessary, the CPU registers the specified board type in the specified group (S135). If plural board types are specified, the CPU 81 makes determinations in steps S120 to S130 for each board type. On the other hand, if the CPU 81 makes a negative determination in any of steps S120 to S130 because exchange of any of the feeder type, the head type, or the nozzle type by an operator is necessary, the CPU 81 displays a group-error message on the display 88 (S140) and returns to step S100. In this case, because the operator cannot include the specified board type in the specified group, the operator respecifies the board type to another group.

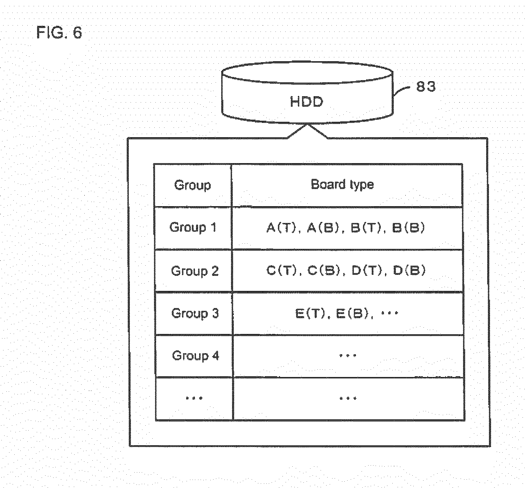

If the CPU 81 determines in step S105 that specification is not accepted or the CPU 81 registers a board type in a group in step S135, the CPU 81 determines whether instruction for the end of input is received on the basis of an operation of an end button (S145). If the CPU 81 determines that instruction for the end of input is not received, the CPU 81 returns to step S105 and repeats the process. On the other hand, if the CPU 81 determines that instruction for the end of input is received, the CPU 81 turns off the specification-accepting screen (S150) and finishes the current process. With the group-specification-accepting process, the CPU 81 stores board types in each group in the grouped-board-type information (group information) on the HDD 83. Fig. 6 illustrates the grouped-board-type information stored on the HDD 83 of the management apparatus 80. In the grouped-board-type information shown in Fig. 6, the board types A(T), A(B), B(T), and B(B) are classified as group 1, the board types C(T) and C(B), D(T), and D(B) are classified as group 2, and the board type E(T), E(B), ... are classified as group 3. Any combination of board types in the same group is a combination that allows continuous operations to be performed. In the example described above, CPU 81 of management apparatus 80 performs manual specification of the group by accepting specification by an operator. However, CPU 81 may perform automatic specification of the group without accepting specification by an operator. In this case, board types on which mounting operations are to be performed by component-mounting system 10 may be successively registered in groups for each of which determination in any of steps S120 to S130 is affirmative. When CPU 81 of management apparatus 80 sends a production job for instructing each component-mounting apparatus 12 to produce a board, CPU 81 includes the board type (board name and top or bottom) and the group name of the board to be produced, the component type, the mounting positions of components, the number of boards to be produced, and the like in the production job when sending the production job.

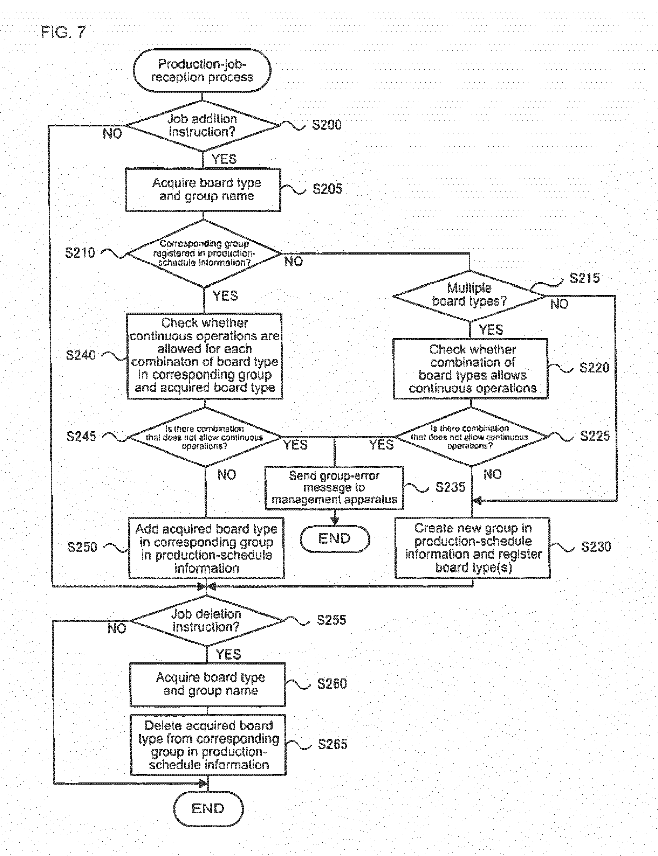

Next, a process that is performed when component-mounting apparatus 12 receives a production job from management apparatus 80 will be described. Fig. 7 is a flowchart of an example of a production-job-reception process. This routine is stored on HDD 73 of controller 70 of each component-mounting apparatus 12 and is executed when controller 70 receives a production job from management apparatus 80. In the production-job-reception process, first, CPU 71 of controller 70 determines whether the production job received from management apparatus 80 includes a job-addition instruction (S200). Here, it is assumed that a production job according to the present embodiment includes at least one of an addition instruction for adding a board type that is scheduled to be produced and a deletion instruction for deleting a board type that is no longer scheduled to be produced (that has been cancelled).

If CPU 71 determines that the received production job includes a job-addition instruction, CPU 71 acquires a board type and a group name included in the addition instruction (S205) and determines whether the corresponding group has been registered in production-schedule information (group information) on HDD 73 (S210). If CPU 71 determines that the corresponding group has not been registered in the production-schedule information, CPU 71 determines whether the number of board types acquired in the current process is more than one (S215). If CPU 71 determines that the number of board types is more than one, CPU 71 checks whether each of the combinations of the acquired board types allows continuous operations to be performed (S220) and determines whether there is a combination that does not allow continuous operations to be performed (S225). Since management apparatus 80 sends a production job that includes a group name based on the group classification of the aforementioned group-specification-accepting process, board types in the same group allow continuous operations to be performed. However, for example, if some production members cannot be used as scheduled due to some trouble in each of the component-mounting apparatuses 12, it may not be possible to perform continuous operations. Therefore, in the present embodiment, when receiving a production job including an addition instruction, controller 70 of each of the component-mounting apparatuses 12 also checks whether a board type may be added to the specified group (whether continuous operations can be performed). Controller 70 may store the production-member information shown in Fig. 5 on HDD 73. Then, in step S220, CPU 71 may check whether continuous operations are allowed by performing operations similar to steps S120 to S130 of the group-specification-accepting process of Fig. 4 with reference to the production-member information on HDD 73.

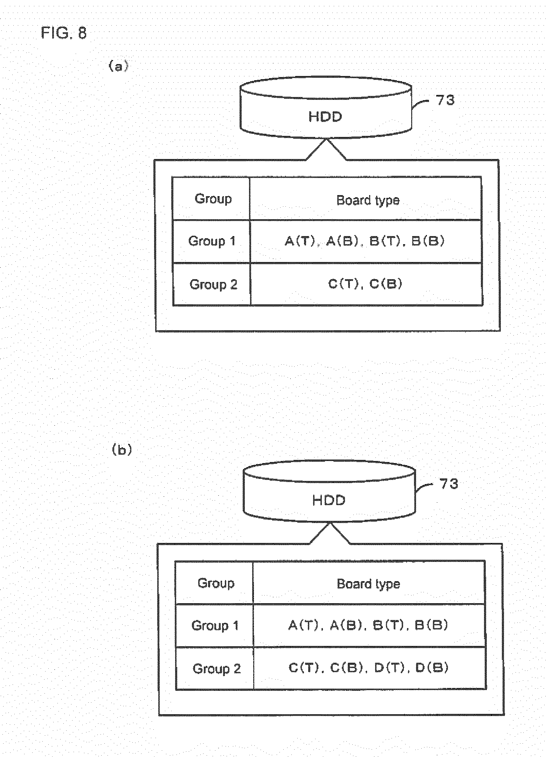

If CPU 71 determines in step S215 that the number of board types is not more than one, or CPU 71 determines in step S225 that there is no combination that does not allow continuous operations to be performed, CPU 71 creates a new group in the production-schedule information and registers the board type or board types in the group (S230). Fig. 8 illustrates production-schedule information stored on HDD 73 of component-mounting apparatus 12. As illustrated in the figure, board types that are scheduled to be produced (board types specified in the production job) are classified into groups and registered. For example, in a state in which only production jobs of board types A(T), A(B), B(T), and B(B) in group 1 is registered in the production-schedule information, if production jobs for producing board types C(T) and C(B) in group 2, which have not been registered, is accepted, CPU 71 performs the following process. That is, in step S220, CPU 71 checks whether continuous operations are allowed for a combination of board types C(T) and C(B); and in step S225, CPU 71 determines that the combination is not a combination that does not allow continuous operations to be performed. Therefore, as illustrated in Fig. 8(a), CPU 71 registers group 2 and board types C(T) and C(B) in the production-schedule information, separately from group 1. If CPU 71 determines in step S225 that there is a combination that does not allow continuous operations to be performed, CPU 71 sends a group-error message to management apparatus 80 (S235) and finishes the current process. When management apparatus 80 receives the group-error message, for example, the management apparatus 80 indicates an error to an operator and prompts the operator to respecify a group.

If CPU 71 determines in step S210 that the corresponding group has been registered in the production-schedule information, CPU 71 checks whether continuous operations are allowed for each of combinations of board types in the corresponding group and the acquired board type (S240) and determines whether there is a combination that does not allow continuous operations to be performed (S245). Also in step S240, CPU 71 checks whether continuous operations are allowed by performing operations similar to steps S120 to S130 of the group-specification-accepting process of Fig. 4 with reference to the production-member information on HDD 73. If CPU 71 determines in step S245 that there is no combination that does not allow continuous operations to be performed, CPU 71 additionally registers the acquired board type in the corresponding group in the production-schedule information (S250) and updates the production-schedule information. For example, if production jobs of board types D(T) and D(B) in group 2 are accepted in a state in which the production-schedule information of Fig. 8(a) is registered, CPU 71 performs the following process. That is, in step S240, CPU 71 checks whether continuous operations are allowed for each of five combinations including board types D(T) and D(B) in addition to board types C(T) and C(B) (excluding the combination of the board types C[T] and C[B], which has already been checked). Then, if CPU 71 determines that there is no combination that does not allow continuous operations to be performed, CPU 71 additionally registers the board types D(T) and D(B) in group 2 (see Fig. 8[b]). On the other hand, if CPU 71 determines in step S245 that there is a combination that does not allow continuous operations to be performed, CPU 71 send a group-error message to management apparatus 80 (S235) and finishes the current process.

If CPU 71 determines in step S200 that the production job does not include a job-addition instruction or performs the operations in step S230 or step S250, CPU 71 determines whether the production job includes a job-deletion instruction (S255). If CPU 71 determines that the production job includes a job-deletion instruction, CPU 71 acquires a board type and a group name included in the deletion instruction (S260), updates the production-schedule information by deleting the acquired board type from the corresponding group in the production-schedule information (S265) and finishes the current process. On the other hand, if CPU 71 determines in step S255 that the production job does not include a job-deletion instruction, CPU 71 immediately finishes the current process.

Next, a process that is performed while each of the component-mounting apparatuses 12 performs mounting operations will be described. During mounting operations, CPU 71 of controller 70 drives head-moving device 40 and head unit 50 so that nozzle 51, which is attached to head 54, moves to a position directly above a supply position on tape feeder 17 of component-supply device 16 to which a type of component to be mounted has been supplied. Subsequently, CPU 71 drives head unit 50 so that nozzle 51 is lowered until the suction inlet of nozzle 51 comes into contact with the component, and causes the nozzle 51 to pick up the component by applying negative pressure to the suction inlet of nozzle 51. Then, CPU 71 controls component camera 48 so that component camera 48 captures an image of the component, which is held by the nozzle 51, when the component is located above component camera 48 and sets a mounting position taking into consideration a correction value of the component orientation based on the captured image. Next, CPU 71 controls head-moving device 40 and head unit 50 so that the nozzle 51 moves to a position above the mounting position on the board. Then, CPU 71 controls head unit 50 so that the nozzle 51 is lowered until the component, which is held by the nozzle 51, comes into contact with the board, and mounts the component by applying positive pressure to the suction inlet of the nozzle 51. When boards are conveyed to two lanes, after finishing the mounting operation on one of the boards conveyed to one of the lanes, component-mounting apparatus 12 starts the mounting operation on the other board conveyed to the other lane. When component-mounting apparatus 12 performs mounting operations on boards of the same type in two lanes, while the mounting operation is being performed in one of the lanes, the component-mounting apparatus 12 loads a board into the other lane. Thus, it is possible to immediately start the mounting operation on the next board without waiting for unloading of a board on which the mounting operation has been performed to be completed and without waiting for loading of the next board.

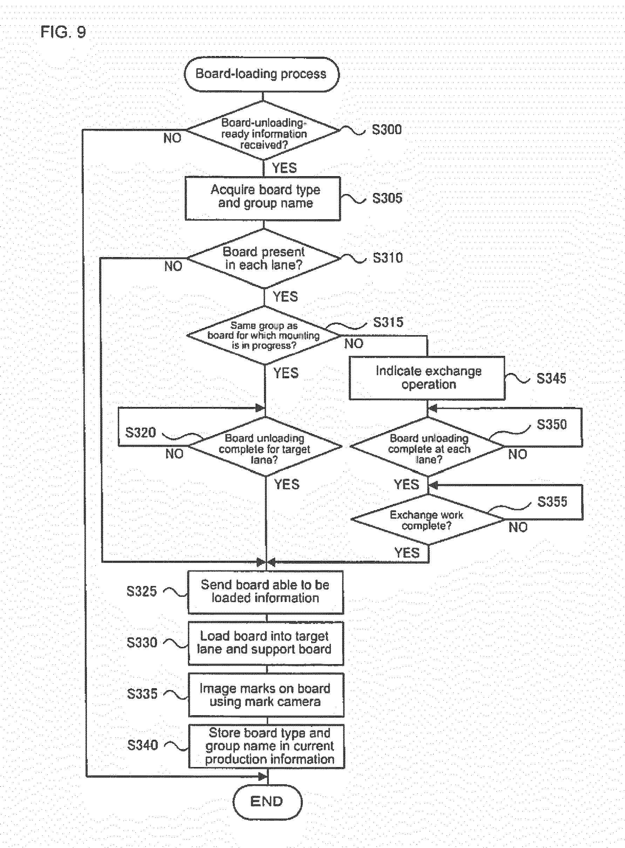

Fig. 9 is a flowchart of an example of a board-loading process. This routine is stored on HDD 73 of controller 70 of each component-mounting apparatus 12 and is performed periodically. In the board-loading process, first, CPU 71 of controller 70 determines whether board-unloading-ready information has been received (S300). The board-unloading-ready information is sent from each component-mounting apparatus 12 to management apparatus 80 when mounting operations are complete and the board is able to be unloaded in a board unloading process performed by component-mounting apparatus 12. The board-unloading-ready information includes a board type and a group name. When receiving board-unloading-ready information, management apparatus 80 sends (forwards) the board-unloading-ready information to the adjacent component-mounting apparatus 12 on the downstream side, in the board conveyance direction, of the component-mounting apparatus 12 that sent the board-unloading-ready information. That is, the board-unloading-ready information is information used to indicate, to the adjacent component-mounting apparatus 12 on the downstream side, that the component-mounting apparatus 12 on the upstream side in the board conveyance direction is able to unload a board. Instead of using such information, whether a board is able to be unloaded may be determined by, for example, detecting that the component-mounting apparatus 12 on the upstream side has conveyed the board to a predetermined unloading position using a sensor. If CPU 71 determines in step S300 that the board-unloading-ready information has not been received, CPU 71 immediately finishes the current process.

If CPU 71 determines in step S300 that the board-unloading-ready information has been received, CPU 71 acquires the board type and group name to be loaded at this time (S305) and then determines whether a board is present in each lane of component-mounting apparatus 12 (S310). If CPU 71 determines that a board is present in each lane, the CPU determines whether the group acquired in step S305 is the same as a group that includes the board type of the board on which the component-mounting apparatus 12 is performing a mounting operation (board type that is present in the lane of component-mounting apparatus 12) (S315). CPU 71 performs the determination in step S315 based on the group name of a board acquired in step S305 and the group name in the present production information stored on HDD 73. The present production information is information to which a board type and a group name on which a mounting operation is being performed is registered in a process described below. If CPU 71 determines in step S315 that the board type on which the mounting operation is being performed and the board type to be loaded at this time are in the same group, CPU 71 waits until unloading of a board from a target lane is complete (S320).

If CPU 71 determines in step S310 that a board is not present in each lane or determines in step S320 that unloading of a board from the target lane is complete, CPU 71 sends board-loading-ready information to management apparatus 80 (S325). When receiving the board-loading-ready information, management apparatus 80 sends (forwards) the board-loading-ready information to the component-mounting apparatus 12 on the upstream side, that is, to the component-mounting apparatus 12 that has sent the board-unloading-ready information. Thus, component-mounting apparatus 12 on the upstream side performs an unloading operation of unloading a board, and CPU 71 controls board-conveyance device 20 and backup device 30 so as to load the unloaded board into the target lane and to support the board (S330). Then, CPU 71 captures an image of a mark on the board using mark camera 46 (S335), associates a board type read from the mark and a group name corresponding to the board type with the lane into which the board has been loaded and stores the board type and the group name in the present production information (S340), and CPU 71 finishes the current process. In step S335, CPU 71 controls head-moving device 40 so that mark camera 46 moves to a position above a mark on the board, and CPU 71 controls mark camera 46 so as to capture an image of the mark. Instead of reading a board type from the mark and storing the board type in the present production information, a board type included in the board-unloading-ready information may be stored in the present production information.

If CPU 71 determines in step S315 that a board type on which mounting operations are being performed and a board type to be loaded at this time are not in the same group but in different groups, because the exchange operation of exchanging production members by an operator is necessary, CPU 71 performs an indication operation of indicating to the operator that the exchange operation is necessary (S345). CPU 71 performs the indication operation by displaying on display/operation panel 14 that the exchange operation is necessary due to switching between board types. Alternatively, the indication operation may be performed as follows: CPU 71 sends information indicating that the exchange operation is necessary to management apparatus 80, and CPU 81 of management apparatus 80 displays on display 88 that the exchange operation is necessary. If HDD 73 of controller 70 stores the production-member information illustrated in Fig. 5, information about production members (feeders 17, head 54, or nozzles 51) that should be exchanged in accordance with switching between board types and information about the types of the production members to be exchanged and the like may be also displayed. When seeing the indication, an operator can recognize that the exchange operation is necessary and can prepare for the exchange operation by, for example, preparing the production members to be exchanged.

After CPU 71 has performed the indication operation of indicating the exchange operation, CPU 71 waits until unloading of a board in each lane on which mounting operations have been performed is complete (S350) and waits until the exchange operation of exchanging the production members by an operator is complete (S355). When the exchange operation of exchanging the production members is complete, the operator operates display/operation panel 14 and inputs information indicating that the exchange operation is complete. When the information is input, CPU 71 determines in step S355 that the exchange operation is complete. If CPU 71 determines that the exchange operation is complete, the CPU sends board-loading-ready information to management apparatus 80 (S325) and informs that a board is ready to be loaded into a target lane of the component-mounting apparatus 12 on the upstream side. Then, CPU 71 loads a board that has been unloaded from the component-mounting apparatus 12 on the upstream side and supports the board (S330), captures an image of a mark on the board by using mark camera 46 (S335), stores the board type and the group name in the present production information (S340), and finishes the current process.

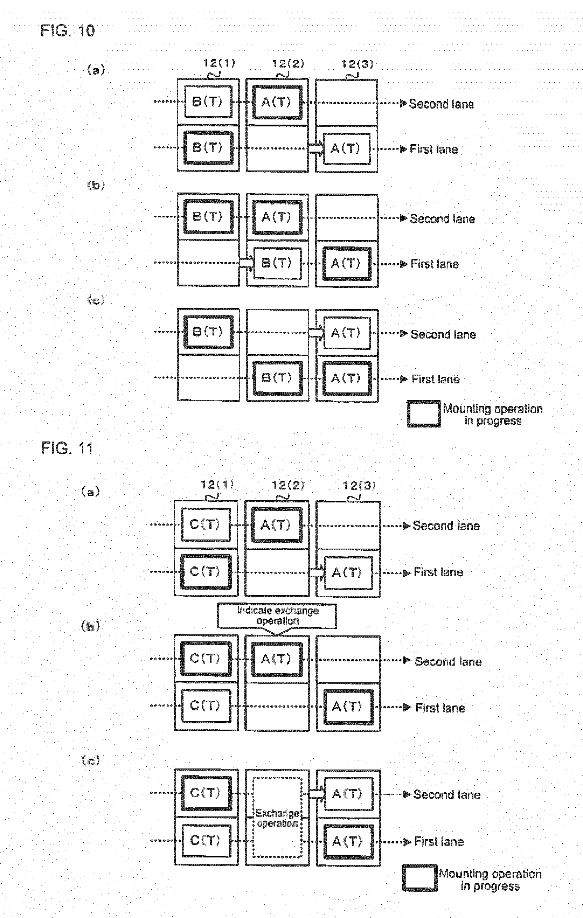

Figs. 10 and 11 each illustrate a state in which boards are being produced in the first lane and the second lane. Figs. 10 and 11 illustrate three component-mounting apparatuses 12 as an example of the multiple component-mounting apparatuses 12. The three component-mounting apparatuses 12 will be referred to as component-mounting apparatuses 12(1), 12(2), and 12(3), from the upstream side in the board conveyance direction (from the left side in the figures). Fig. 10(a) illustrates a state in which the component-mounting apparatus 12(2) has finished performing mounting operations on a board in the first lane, which is one of the boards of board type A(T) in the first and second lanes, and has unloaded the board to the component-mounting apparatus 12(3) on the downstream side. It is assumed that boards of board type B(T) are present in the first and second lanes of the component-mounting apparatus 12(1) and a mounting operation on a board of the board type B(T) in the first lane is to finish first. When a board of the board type B(T) becomes ready to be unloaded in the first lane of the component-mounting apparatus 12(1), controller 70 (CPU 71) of the component-mounting apparatus 12(2) on the downstream side determines that board type B(T), which is able to be unloaded, and the board type A(T), which is present in the second lane, are in the same group (see Fig. 8). Therefore, controller 70 of the component-mounting apparatus 12(2) loads a board of the board type B(T) into the first lane while mounting operations are being performed on a board of the board type A(T) in the second lane (Fig. 10[b]). Therefore, the component-mounting apparatus 12(2) can start a mounting operation on a board of the board type B(T) immediately after mounting operations on a board of the board type A(T) in the second lane are complete (Fig. 10(c)). Thus, when component-mounting apparatus 12 conveys boards of different types to the lanes and performs mounting operation, component-mounting apparatus 12 can increase the production efficiency by reducing waiting time when switching between board types (by switching between the board types quickly) by loading the next board beforehand if boards in the same group are conveyed successively. Moreover, component-mounting apparatus 12 can immediately determine whether the boards are in the same group on the basis of the production-schedule information (group information) stored on HDD 73.

Fig. 11(a) illustrates the same state as Fig. 10(a) except that board type C(T), instead of board type B(T), is present in each of the first and second lanes of component-mounting apparatus 12(1). When a board of board type C(T) is able to be unloaded in the first lane of the component-mounting apparatus 12(1), controller 70 of the component-mounting apparatus 12(2) on the downstream side determines that the board type C(T), which has become ready to be conveyed, is not in the same group as the board type A(T), which is present in the second lane (see Fig. 8). Therefore, controller 70 of component-mounting apparatus 12(2) performs an indication operation of indicating an exchange operation without loading a board of the board type C(T) into the first lane while a mounting operation is being performed on a board of the board type A(T) in the second lane (Fig. 11[b]). When seeing the indication, an operator can prepare for the exchange operation. Therefore, when the component-mounting apparatus 12(2) has finished producing a board of the board type A(T) in the second lane and unloads the board, the operator can immediately perform the exchange operation (Fig. 11[c]). Thus, when switching to a board in a different group, component-mounting apparatus 12 indicates to an operator that the exchange operation of exchanging production members is necessary before unloading a board on which a mounting operation is being performed, thereby enabling the operator to immediately perform the exchange operation. Therefore, even when switching to a board in a different group, it is possible to reduce the time required for switching between board types, including the time needed to perform the exchange operation of exchanging production members.

Here, correspondences between elements in the present embodiment and elements in the present invention will be described. HDD 73 of controller 70 and HDD 83 of management apparatus 80 of component-mounting apparatus 12 in the present embodiment correspond to a storage section in the present invention. Tape feeders 17 correspond to component-supply members. Nozzles 51 and heads 54 correspond to component-holding members. CPU 71 of controller 70 that performs step S305 of the board-loading process in Fig. 9 corresponds to an acquisition section. CPU 71 of controller 70 that performs step S310 of the process corresponds to a combination-determining unit. CPU 71 of controller 70 that performs steps S320 and S325 if the determination in step S310 of the board-loading process is affirmative corresponds to a loading controller. CPU 71 of controller 70 that performs step S345 if the determination in step S310 of the process is negative also corresponds to a loading controller. CPU 71 of controller 70 that performs step S340 of the board-loading process and display/operation panel 14 correspond to an indication unit. CPU 81 of management apparatus 80 that performs steps S100 and S105 of the group-specification-accepting process shown in Fig. 4, display 88 that displays a specification-accepting screen, and input device 87 operated by an operator correspond to a specification-accepting section. CPU 81 of management apparatus 80 that performs steps S110 and S115 of the process corresponds to a production-member-type acquiring unit. CPU 81 of management apparatus 80 that performs steps S120 to S130 of the process corresponds to an exchange operation determining unit.

In component-mounting system 10 described above, each of the component-mounting apparatuses 12 is configured to allow production members to be exchanged in accordance with the type of the board, the production members including multiple types of tape feeders 17 for supplying different types of components and multiple types of nozzles 51 and heads 54 for holding different types of components. Component-mounting system 10 stores group information (production-schedule information, grouped-board-type information) in which the multiple types of boards are divided into groups each of which allows continuous operations to be performed without requiring an operator to perform an exchange operation of exchanging the production members. Therefore, it is possible to reduce the processing time for determining whether the combination of boards to be processed in the lanes is a combination that allows continuous operations to be performed. Accordingly, it is possible to increase the efficiency of a board production apparatus, the apparatus having a dual-lane structure in which two lanes capable of conveying multiple types of boards are arranged in parallel.

Component-mounting system 10 determines whether a combination of board types on which a mounting operation is to be performed in two lanes is a combination that allows continuous operations to be performed, based on the board types on which the mounting operations are to be performed and production-schedule information. Therefore, regarding the combination of board types on which mounting operations are to be performed in two lanes, it is possible to immediately check whether exchange operation of exchanging the production members is necessary and the like. If the combination of a board that is able to be conveyed from the component-mounting apparatus 12 on the upstream side in a first lane and a board on which mounting operations are being performed by the component-mounting apparatus 12 on the downstream side in the other lane is a combination that allows continuous operations to be performed, the component-mounting system 10 loads, into the component-mounting apparatus 12 on the downstream side, the board that is able to be conveyed. Therefore, component-mounting system 10 can immediately start a mounting operation on the next board. Since component-mounting system 10 does not convey a board while a mounting operation is being performed if the combination is not a combination that allows continuous operations to be performed, it is possible to prevent decrease of the efficiency of the exchange operation of exchanging the production members. If the combination of board types on which mounting operations are to be performed in two lanes is not a combination that allows continuous operations to be performed, component-mounting system 10 indicates that the exchange operation of exchanging the production members is necessary. Therefore, it is possible for an operator to prepare for the exchange operation and smoothly perform the exchange operation.

When component-mounting system 10 accepts specification of a board type and a group from an operator, component-mounting system 10 stores group information in which board types are divided into groups based on the determination that it is not necessary to perform the exchange operation of exchanging the production members for the specified board type and another board type in the specified group. Therefore, it is possible to improve the reliability of the group information.

The present invention is not limited to the embodiment described above and can be carried out in various embodiments within the technical scope as defined by the claims of the present invention.

For example, in the embodiment described above, management apparatus 80 performs the group-specification-accepting process of accepting specification of a board type and a group from an operator; however, the configuration is not limited to this, component-mounting apparatus 12 may perform the group-specification-accepting process. Alternatively, only determination of a combination (a process of accepting specification of a board type and a group from an operator and determining whether an exchange operation of exchanging the production members is necessary for the specified board type and another board type in the specified group) may be performed. Alternatively, specification of a board type and a group need not be accepted from an operator (instead of manual specification, only automatic specification may be performed).

In the embodiment described above, as group information, the grouped-board-type information is stored on HDD 83 of management apparatus 80, and the production-schedule information is stored on HDD 73 of component-mounting apparatus 12 of controller 70; however, the configuration is not limited to this, the group information may be stored on one of HDD 83 and HDD 73. In this case, management apparatus 80 and controller 70 may acquire necessary information from the group information stored on one of the HDDs via communication.

In the embodiment described above, both of the component-holding members and the component-supply members correspond to production members to be exchanged by an operator; however, the configuration is not limited to this, only one the component-holding members and the component-supply members may correspond to production members to be exchanged by an operator. Nozzles 51 in nozzle rack 60 and head 54 attached to head unit 50 are described as examples of component-holding members to be exchanged by an operator; the configuration is not limited to this, only one of nozzles 51 and head 54 may be a component-holding member to be exchanged by an operator. Tape feeders 17 are described as examples of component-supply members to be exchanged by an operator; however the configuration is not limited to this, for example, component-supply members to be exchanged by an operator may be bulk feeders that contain multiple loose components and supply the components after aligning them, or tray feeders that holds multiple components on a flat-plate-shaped tray to supply them.

Production members to be exchanged by an operator are not limited to component-holding members and component-supply members and may be other members. For example, if component-mounting apparatus 12 is configured to allow types of component cameras 48 to be exchanged in accordance with the types of components to be mounted, component camera 48 may be a production members to be exchanged. Alternatively, if component-mounting apparatus 12 is configured to allow the types of backup pins 34 of backup devices 30 to be exchanged in accordance with board types on which mounting operations are to be performed, backup pins 34 may be production members to be exchanged.

In the embodiment described above, the combination of board types is checked (whether continuous operations are allowed to be performed is determined) when component-mounting apparatus 12 receives a production job; however the configuration is not limited to this. As described above, because management apparatus 80 performs checking of the combination of board types, checking of the combination when component-mounting apparatus 12 receives a production job may be omitted. In this case, steps S215 to S225 and steps S235 to S245 in the production-job-reception process may be omitted.

In the embodiment described above, two lanes, first lane 22a and second lane 22b, are provided; however, the configuration is not limited to this, multiple lanes, for example, three lanes, may be provided.

In the embodiment described above, component-mounting apparatus 12 includes only one head unit 50; however, the configuration is not limited to this, component-mounting apparatus 12 may include two head units corresponding to two lanes. The two head units may share one nozzle rack.

### Industrial Applicability

The present invention is applicable to the manufacturing industry of manufacturing component-mounting apparatuses for mounting components on a board.

### Reference signs list

- 10: component-mounting system
- 12: component-mounting apparatus
- 14: display/operation panel
- 16: component-supply device
- 17: tape feeder
- 20: board-conveyance device
- 22a: first lane
- 22b: second lane
- 24a, 24b: belt conveyer device
- 30: backup device
- 32: backup plate
- 34: backup pin
- 40: head-moving device
- 41: X-axis guide rail
- 42: X-axis slider
- 43: Y-axis guide rail
- 44: Y-axis slider
- 46: mark camera
- 48: component camera
- 50: head unit
- 51: nozzle
- 52: nozzle holder
- 54: head
- 54a to 54c: first to third heads
- 55: R-axis motor
- 56: θ-axis motor
- 57: Z-axis motor
- 60: nozzle rack
- 70: controller
- 71, 81: CPU
- 72, 82: ROM
- 73, 83: HDD
- 74, 84: RAM
- 75, 85: input/output interface
- 76, 86: bus
- 80: management apparatus
- 87: input device
- 88: display

## Claims

1. A component-mounting system (10) comprising:
multiple component-mounting apparatuses (12) in each of which multiple lanes (22a, 22b) capable of conveying multiple types of boards are arranged in parallel and that perform a mounting operation of picking up and holding supplied components and mounting the components on the boards, the multiple component-mounting apparatuses (12) being arranged in a conveyance direction of the boards, and the multiple component-mounting apparatuses (12) being configured to allow types of at least one of a production member (17, 51, 54) to be exchanged in accordance with the type of the board, the production member (17, 51, 54) including multiple types of component supply members (17) for supplying different types of the components and multiple types of component holding members (51, 54) for holding different types of the components;
a storage section (73, 83) configured to store group information in which the multiple types of boards are divided into groups, each of which allows the mounting operation of all types of boards of a group to be performed without requiring an operator to perform an exchange operation of exchanging the production members (17, 51, 54),
an acquisition section (71) configured to acquire the types of the boards on which the mounting operation is to be performed;
a combination-determining unit (71) configured to determine whether a combination of the types of the boards on which the mounting operation is to be performed in the multiple lanes (22a, 22b) is a combination that does not require the exchange operation of exchanging the production members (17, 51, 54) based on the types of the boards acquired by the acquisition section (71) and the group information stored in the storage section (73, 83);
**characterized by**:
a loading controller (71) configured to, when it is possible to convey the board in a first lane (22a) from one of the component-mounting apparatuses (12) on an upstream side in the board conveyance direction to another of the component-mounting apparatuses (12) on a downstream side and if the combination-determining unit (71) has determined that a combination of the board that is possible to convey in the first lane (22a) and a board loaded into the component-mounting apparatus (12) on the downstream side in a second lane (22b) is a combination that does not require the exchange operation of exchanging the production members (17, 51, 54), perform control so as to load the board that is possible to convey in the first lane (22a) into the component-mounting apparatus (12) on the downstream side.

2. The component-mounting system (10) according to Claim 1,
wherein the loading controller (71) is configured to perform control so as not to load the board that is possible to convey in the first lane (22a) into the component-mounting apparatus (12) on the downstream side until the exchange operation of exchanging the production members (17, 51, 54) is complete, if the combination-determining section (71) has determined that the combination of the board that is possible to convey in the first lane (22a) and the board loaded into the component-mounting apparatus (12) on the downstream side in the second lane (22b) is not a combination that does not require the exchange operation of exchanging the production members (17, 51, 54).

3. The component-mounting system (10) according to Claim 1 or 2,
wherein the combination-determining section (71) in the component-mounting apparatus (12) on the downstream side is configured to determine whether the combination of the board that is possible to convey in the first lane (22a) and the board loaded into the component-mounting apparatus (12) on the downstream side in the second lane (22b) is a combination that does not require the exchange operation of exchanging the production members (17, 51, 54).

4. The component-mounting system (10) according to any one of Claims 1 to 3, comprising:
an indication section (71, 14) configured to indicate information that the operator needs to perform the exchange operation of exchanging the production members (17, 51, 54) if the combination-determining section (71) determines that the combination of the types of boards on which the mounting operation is to be performed in the multiple lanes (22a, 22b) is not a combination that does not require the exchange operation of exchanging the production members (17, 51, 54).

5. A component-mounting apparatus (12) configured to be used in a component-mounting system (10) according to any one of Claims 1 to 4, and to perform a mounting operation of picking up and holding supplied components and mounting the components on boards, the component-mounting apparatus (12) comprising:
multiple lanes (22a, 22b) capable of conveying multiple types of boards arranged in parallel, the component-mounting apparatus (12) being configured to allow types of at least one of a production member (17, 51, 54) to be exchanged in accordance with the type of the board, the production member (17, 51, 54) including multiple types of component supply members (17) for supplying different types of the components and multiple types of component holding members (51, 54) for holding different types of the components, and
a storage section (73, 83) configured to store group information in which the multiple types of boards are divided into groups, each of which allows the mounting operation of all types of boards of a group to be performed without requiring an operator to perform an exchange operation of exchanging the production members (17, 51, 54),
an acquisition section (71) configured to acquire the types of the boards on which the mounting operation is to be performed;
a combination-determining unit (71) configured to determine whether a combination of the types of the boards on which the mounting operation is to be performed in the multiple lanes (22a, 22b) is a combination that does not require the exchange operation of exchanging the production members (17, 51, 54) based on the types of the boards acquired by the acquisition section (71) and the group information stored in the storage section (73, 83);
**characterized by**:
a loading controller (71) configured to, when it is possible to convey the board in a first lane (22a) from one of the component-mounting apparatuses (12) on an upstream side in the board conveyance direction to another of the component-mounting apparatuses (12) on a downstream side and if the combination-determining unit (71) has determined that a combination of the board that is possible to convey in the first lane (22a) and a board loaded into the component-mounting apparatus (12) on the downstream side in a second lane (22b) is a combination that does not require the exchange operation of exchanging the production members (17, 51, 54), perform control so as to load the board that is possible to convey in the first lane (22a) into the component-mounting apparatus (12) on the downstream side.

## Patentansprüche

1. Komponentenmontagesystem (10), umfassend:
mehrere Komponentenmontagevorrichtungen (12), in denen jeweils mehrere Bahnen (22a, 22b), die mehrere Typen von Platten fördern können, parallel angeordnet sind und die eine Montagetätigkeit des Aufnehmens und Haltens von zugeführten Komponenten und des Montierens der Komponenten auf den Platten ausführen, wobei die mehreren Komponentenmontagevorrichtungen (12) in einer Förderrichtung der Platten angeordnet sind, und die mehreren Komponentenmontagevorrichtungen (12) konfiguriert sind, zuzulassen, dass Typen von mindestens einem von einem Produktionselement (17, 51, 54) gemäß dem Typ der Platte ausgetauscht werden, wobei das Produktionselement (17, 51, 54) mehrere Typen von Komponentenzuführelementen (17) zum Zuführen verschiedener Typen der Komponenten und mehrere Typen von Komponentenhalteelementen (51, 54) zum Halten unterschiedlicher Typen der Komponenten umfasst;
einen Speicherabschnitt (73, 83), der konfiguriert ist, Gruppeninformationen zu speichern, in denen die mehreren Typen von Platten in Gruppen aufgeteilt sind, von denen jede ermöglicht, dass die Montagetätigkeit aller Typen von Platten einer Gruppe ausgeführt wird, ohne zu erfordern, dass eine Bedienperson einen Austauschvorgang des Austauschens der Produktionselemente (17, 51, 54) ausführt,
einen Erfassungsabschnitt (71), der konfiguriert ist, die Typen der Platten zu erfassen, auf denen die Montagetätigkeit auszuführen ist;
eine Kombinationsbestimmungseinheit (71), die konfiguriert ist, basierend auf den von dem Erfassungsabschnitt (71) erfassten Typen der Platten und den in dem Speicherabschnitt (73, 83) gespeicherten Gruppeninformationen zu bestimmen, ob eine Kombination der Typen der Platten, auf denen die Montagetätigkeit in den mehreren Bahnen (22a, 22b) auszuführen ist, eine Kombination ist, die keinen Austauschvorgang des Austauschens der Produktionselemente (17, 51, 54) erfordert;
**gekennzeichnet durch**:
eine Ladesteuerung (71), die konfiguriert ist, wenn es möglich ist, die Platte in einer ersten Bahn (22a) von einer der Komponentenmontagevorrichtungen (12) auf einer vorgelagerten Seite in der Plattenförderrichtung zu einer anderen der Komponentenmontagevorrichtungen (12) auf einer nachgelagerten Seite zu fördern und wenn die Kombinationsbestimmungseinheit (71) bestimmt hat, dass eine Kombination der Platte, die in der ersten Bahn (22a) gefördert werden kann und einer Platte, die in die Komponentenmontagevorrichtung (12) auf der nachgelagerten Seite in einer zweiten Bahn (22b) geladen ist, eine Kombination ist, die den Austauschvorgang des Austauschens der Produktionselemente (17, 51, 54) nicht erfordert, eine Steuerung auszuführen, um die Platte, die in der ersten Bahn (22a) gefördert werden kann, in die Komponentenmontagevorrichtung (12) auf der nachgelagerten Seite zu fördern.

2. Das Komponentenmontagesystem (10) nach Anspruch 1,
wobei die Ladesteuerung (71) konfiguriert ist, eine Steuerung auszuführen, um die Platte, die in der ersten Bahn (22a) gefördert werden kann, in die Komponentenmontagevorrichtung (12) auf der nachgelagerten Seite nicht zu laden, bis der Austauschvorgang des Austauschens der Produktionselemente (17, 51, 54) vollständig ist, wenn der Kombinationsbestimmungsabschnitt (71) bestimmt hat, dass die Kombination der Platte, die in der ersten Bahn (22a) gefördert werden kann und der Platte, die in die Komponentenmontagevorrichtung (12) auf der nachgelagerten Seite in der zweiten Bahn (22b) geladen ist, keine Kombination ist, die den Austauschvorgang des Austauschens der Produktionselemente (17, 51, 54) nicht erfordert.

3. Das Komponentenmontagesystem (10) nach Anspruch 1 oder 2,
wobei der Kombinationsbestimmungsabschnitt (71) in der Komponentenmontagevorrichtung (12) auf der nachgelagerten Seite konfiguriert ist, zu bestimmen, ob die Kombination der Platte, die in der ersten Bahn (22a) gefördert werden kann und der Platte, die in die Komponentenmontagevorrichtung (12) auf der nachgelagerten Seite in der zweiten Bahn (22b) geladen ist, eine Kombination ist, die den Austauschvorgang des Austauschens der Produktionselemente (17, 51, 54) nicht erfordert.

4. Das Komponentenmontagesystem (10) nach einem der Ansprüche 1 bis 3, umfassend:
einen Anzeigeabschnitt (71, 14), der konfiguriert ist, Informationen anzuzeigen, die die Bedienperson benötigt, um den Austauschvorgang des Austauschens der Produktionselemente (17, 51, 54) auszuführen, wenn der Kombinationsbestimmungsabschnitt (71) bestimmt, dass die Kombination der Typen der Platten, auf denen die Montagetätigkeit in den mehreren Bahnen (22a, 22b) auszuführen ist, keine Kombination ist, die den Austauschvorgang des Austauschens der Produktionselemente (17, 51, 54) nicht erfordert.

5. Komponentenmontagevorrichtung (12), die konfiguriert ist, in einem Komponentenmontagesystem (10) nach einem der Ansprüche 1 bis 4 verwendet zu werden, und eine Montagetätigkeit des Aufnehmens und Haltens zugeführter Komponenten und des Montierens der Komponenten auf Platten auszuführen, wobei die Komponentenmontagevorrichtung (12) umfasst:
mehrere Bahnen (22a, 22b), die mehrere Typen von Platten fördern können, die parallel angeordnet sind, wobei die Komponentenmontagevorrichtung (12) konfiguriert ist, zuzulassen, dass Typen von mindestens einem von einem Produktionselement (17, 51, 54) in Übereinstimmung mit dem Typ der Platte ausgetauscht werden, wobei das Produktionselement (17, 51, 54) mehrere Typen von Komponentenzuführelementen (17) zum Zuführen verschiedener Typen der Komponenten und mehrere Typen von Komponentenhalteelementen (51, 54) zum Halten verschiedener Typen der Komponenten umfasst, und
einen Speicherabschnitt (73, 83), der konfiguriert ist, Gruppeninformationen zu speichern, in denen die verschiedenen Typen der Platten in Gruppen aufgeteilt sind, von denen jede ermöglicht, dass die Montagetätigkeit aller Typen von Platten einer Gruppe ausgeführt wird, ohne zu erfordern, dass eine Bedienperson einen Austauschvorgang des Austauschens der Produktionselemente (17, 51, 54) ausführt,
einen Erfassungsabschnitt (71), der konfiguriert ist, die Typen der Platten zu erfassen, auf denen die Montagetätigkeit auszuführen ist;
eine Kombinationsbestimmungseinheit (71), die konfiguriert ist, basierend auf den von dem Erfassungsabschnitt (71) erfassten Typen der Platten und den in dem Speicherabschnitt (73, 83) gespeicherten Gruppeninformationen zu bestimmen, ob eine Kombination der Typen der Platten, auf denen die Montagetätigkeit in den mehreren Bahnen (22a, 22b) auszuführen ist, eine Kombination ist, die den Austauschvorgang des Austauschens der Produktionselemente (17, 51, 54) nicht erfordert;
**gekennzeichnet durch**:
eine Ladesteuerung (71), die konfiguriert ist, wenn es möglich ist, die Platte in einer ersten Bahn (22a) von einer der Komponentenmontagevorrichtungen (12) auf einer vorgelagerten Seite in der Plattenförderrichtung zu einer anderen der Komponentenmontagevorrichtungen (12) auf einer nachgelagerten Seite zu fördern und wenn die Kombinationsbestimmungseinheit (71) bestimmt hat, dass eine Kombination der Platte, die in der ersten Bahn (22a) gefördert werden kann und einer Platte, die in die Komponentenmontagevorrichtung (12) auf der nachgelagerten Seite in einer zweiten Bahn (22b) geladen ist, eine Kombination ist, die den Austauschvorgang des Austauschens der Produktionselemente (17, 51, 54) nicht erfordert, eine Steuerung auszuführen, um die Platte, die in der ersten Bahn (22a) gefördert werden kann, in die Komponentenmontagevorrichtung (12) auf der nachgelagerten Seite zu fördern.

## Revendications

1. Système de montage de composants (10) comprenant :
de multiples appareils de montage de composants (12) dans chacun desquels sont agencées en parallèle de multiples lignes (22a, 22b) pouvant transporter de multiples types de cartes, lesquels effectuent une opération de montage consistant à prélever et à maintenir des composants délivrés et à monter les composants sur les cartes, les multiples appareils de montage de composants (12) étant disposés dans la direction de transport des cartes, et les multiples appareils de montage de composants (12) étant configurés pour autoriser l'échange de types d'au moins l'un d'un élément de fabrication (17, 51, 54) en fonction du type de la carte, l'élément de fabrication (17, 51, 54) incluant de multiples types d'éléments de délivrance de composant (17) destinés à fournir différents types de composants, ainsi que de multiples types d'éléments de maintien de composants (51, 54) destinés à maintenir différents types de composants,
une section de stockage (73, 83) configurée pour stocker des informations de groupe dans lesquels les multiples types de cartes sont divisées en groupes, chacun desquels autorisant l'opération consistant à effectuer le montage de tous les types de cartes d'un groupe sans avoir besoin qu'un opérateur effectue une opération d'échange des éléments de fabrication (17, 51, 54),
une section d'acquisition (71) configurée pour acquérir les types de cartes sur lesquels doit être effectuée l'opération de montage,
une unité de détermination de combinaison (71) configurée pour déterminer si une combinaison des types de cartes sur lesquels doit être effectuée l'opération de montage sur les multiples lignes (22a, 22b) est une combinaison qui ne demande pas d'opération d'échange des éléments de fabrication (17, 51, 54) sur la base des types de cartes acquis par la section d'acquisition (71) et sur les informations de groupes stockées dans la section de stockage (73, 83),
**caractérisé par** :
un contrôleur de chargement (71) configuré pour effectuer une commande, lorsqu'il est possible de transporter la carte sur une première ligne (22a) depuis l'un des appareils de montage de composants (12) en amont dans la direction de transport des cartes vers un autre des appareils de montage de composants (12) en aval, et si l'unité de détermination de combinaison (71) a défini qu'une combinaison de la carte qu'il est possible de transporter sur la première ligne (22a) et d'une carte chargée dans l'appareil de montage de composants (12) en aval sur une seconde ligne (22b) est une combinaison qui n'a pas besoin d'opération d'échange des éléments de fabrication (17, 51, 54), de sorte à charger la carte qu'il est possible de transporter sur la première ligne (22a) dans l'appareil de montage de composants (12) en aval.

2. Système de montage de composants (10) selon la revendication 1,
dans lequel le contrôleur de chargement (71) est configuré pour effectuer une commande de sorte à ne pas charger la carte qu'il est possible de transporter sur la première ligne (22a) dans l'appareil de montage de composants (12) en aval jusqu'à ce que l'opération d'échange des éléments de fabrication (17, 51, 54) soit achevée, si la section de détermination de combinaison (71) a défini que la combinaison de la carte qu'il est possible de transporter sur la première ligne (22a) et la carte chargée dans l'appareil de montage de composants (12) en aval sur la seconde ligne (22b) n'est pas une combinaison qui ne demande pas d'opération d'échange des éléments de fabrication (17, 51, 54) .

3. Système de montage de composants (10) selon la revendication 1 ou la revendication 2,
dans lequel la section de détermination de combinaison (71) dans l'appareil de montage de composants (12) en aval est configurée pour déterminer si la combinaison de la carte qu'il est possible de transporter sur la première ligne (22a) et la carte chargée dans l'appareil de montage de composants (12) en aval sur la seconde ligne (22b) et une combinaison qui ne demande pas d'opération d'échange des éléments de fabrication (17, 51, 54).

4. Système de montage de composants (10) selon l'une quelconque des revendications 1 à 3, comprenant :
une section d'indication (71, 14) configurée pour montrer l'information indiquant que l'opérateur a besoin d'effectuer l'opération d'échange des éléments de fabrication (17, 51, 54) si la section de détermination de combinaison (71) détermine que la combinaison des types de cartes sur lesquels doit être effectuée l'opération de montage sur les multiples lignes (22a, 22b) n'est pas une combinaison qui ne demande pas l'opération d'échange des éléments de fabrication (17, 51, 54).

5. Appareil de montage de composants (12) configuré pour être utilisé dans un système de montage de composants (10) conforme à l'une quelconque des revendications 1 à 4, et pour effectuer une opération de montage consistant à prélever et à maintenir des composants délivrés et à monter les composants sur des cartes, l'appareil de montage de composants (12) comprenant :
de multiples lignes (22a, 22b) pouvant transporter de multiples types de cartes agencés en parallèle, l'appareil de montage de composants (12) étant configuré pour autoriser l'échange de types d'au moins l'un d'un élément de fabrication (17, 51, 54) en fonction du type de la carte, l'élément de fabrication (17, 51, 54) incluant de multiples types d'éléments de délivrance de composant (17) destinés à fournir différents types de composants, ainsi que de multiples types d'éléments de maintien de composants (51, 54) destinés à maintenir différents types de composants, et
une section de stockage (73, 83) configurée pour stocker des informations de groupe dans lesquels les multiples types de cartes sont divisées en groupes, chacun desquels autorisant l'opération consistant à effectuer le montage de tous les types de cartes d'un groupe sans avoir besoin qu'un opérateur effectue une opération d'échange des éléments de fabrication (17, 51, 54),
une section d'acquisition (71) configurée pour acquérir les types de cartes sur lesquels doit être effectuée l'opération de montage,
une unité de détermination de combinaison (71) configurée pour déterminer si une combinaison des types de cartes sur lesquels doit être effectuée l'opération de montage sur les multiples lignes (22a, 22b) est une combinaison qui ne demande pas d'opération d'échange des éléments de fabrication (17, 51, 54) sur la base des types de cartes acquis par la section d'acquisition (71) et sur les informations de groupes stockées dans la section de stockage (73, 83),
**caractérisé par** :
un contrôleur de chargement (71) configuré pour effectuer une commande, lorsqu'il est possible de transporter la carte sur une première ligne (22a) depuis l'un des appareils de montage de composants (12) en amont dans la direction de transport des cartes vers un autre des appareils de montage de composants (12) en aval, et si l'unité de détermination de combinaison (71) a défini qu'une combinaison de la carte qu'il est possible de transporter sur la première ligne (22a) et d'une carte chargée dans l'appareil de montage de composants (12) en aval sur une seconde ligne (22b) est une combinaison qui ne demande pas d'opération d'échange des éléments de fabrication (17, 51, 54), de sorte à charger la carte qu'il est possible de transporter sur la première ligne (22a) dans l'appareil de montage de composants (12) en aval.
